# EUROPEAN PATENT SPECIFICATION

(11) **EP 2 533 274 B1**
(45) Date of publication and mention of the grant of the patent: **30.07.2014**
(21) Application number: 11736868.8
(22) Date of filing: 17.01.2011
(51) Int. Cl.: H01L 21/3105, C09G 1/02, C09K 3/14, B24B 13/015, B24B 29/02, B24B 37/04

(54) **AQUEOUS DISPERSION FOR CHEMICAL MECHANICAL POLISHING, AND CHEMICAL MECHANICAL POLISHING METHOD USING SAME**
WÄSSRIGE DISPERSION ZUM CHEMISCHEN UND MECHANISCHEN POLIEREN SOWIE VERFAHREN ZUM CHEMISCHEN UND MECHANISCHEN POLIEREN DAMIT
DISPERSION AQUEUSE POUR LE POLISSAGE CHIMIQUE-MÉCANIQUE, ET PROCÉDÉ DE POLISSAGE CHIMIQUE-MÉCANIQUE UTILISANT CELLE-CI

(30) Priority: 01.02.2010 JP 2010020109
(43) Date of publication of application: 12.12.2012
(73) Proprietor: JSR Corporation, Minato-ku Tokyo 105-8640 (JP)
(72) Inventor: TAKEMURA, Akihiro, Tokyo 105-8640 (JP); YOSHIO, Kouhei, Tokyo 105-8640 (JP); YAMANAKA, Tatsuya, Tokyo 105-8640 (JP); KONNO, Tomohisa, Tokyo 105-8640 (JP)
(74) Representative: TBK
(86) International application number: PCT/JP2011/050624
(87) International publication number: WO 2011/093153

(56) References cited:
- WO-A1-2010/134542
- WO-A1-2012/026329
- JP-A- 2006 120 728
- JP-A- 2006 524 918
- JP-A- 2007 234 784
- JP-A- 2007 527 471
- JP-A- 2008 519 466
- JP-A- 2010 269 985
- JP-A- 2011 020 208
- US-A1- 2004 209 555
- US-A1- 2007 202 703
- US-A1- 2010 009 538
- YOUNG-KWON OH ET AL: "Synthesis of Super-hydrophilic Mesoporous Silica via a Sulfonation Route", JOURNAL OF INDUSTRIAL AND ENGINEERING CHEMISTRY, AMERICAN CHEMICAL SOCIETY, EASTON, PA, US, vol. 12, no. 6, 1 January 2006 (2006-01-01), pages 911-917, XP002691533, ISSN: 0095-9014
- MAJEWSKI P: "Interaction of functionalised surfaces on silica with dissolved metal cations in aqueous solutions", INTERNATIONAL JOURNAL OF MATERIALS RESEARCH CARL HANSER GMBH GERMANY, vol. 97, no. 6, June 2006 (2006-06), pages 784-788, XP008162205, ISSN: 1862-5282

## Description

### TECHNICAL FIELD

The present invention relates to a chemical mechanical polishing aqueous dispersion, and a chemical mechanical polishing method using the chemical mechanical polishing aqueous dispersion.

### BACKGROUND ART

A known chemical mechanical polishing aqueous dispersion normally achieves a practical polishing rate when chemically and mechanically polishing a silicon oxide film or a polysilicon film, but does not achieve a practical polishing rate when chemically and mechanically polishing a silicon nitride film. Therefore, a silicon oxide film formed on a silicon nitride film has been normally removed by chemical mechanical polishing (hereinafter may be referred to as "CMP") using the silicon nitride film as a stopper. The silicon nitride film used as the stopper is removed after removing the silicon oxide film.

A silicon nitride film may be removed by etching using hot phosphoric acid. In this case, since the etching treatment is controlled based on the etching time, the silicon nitride film may not be completely removed, or a layer under the silicon nitride film may be damaged. Therefore, a method that also removes a silicon nitride film by CMP has been desired.

In order to selectively remove a silicon nitride film by CMP, the polishing rate ratio of a silicon nitride film to a silicon oxide film (hereinafter may be referred to as "selectivity ratio") must be sufficiently increased. Some chemical mechanical polishing aqueous dispersions having such properties have been proposed as described below.

For example, JP-A-11-176773 discloses a method that selectively polishes a silicon nitride film using a polishing agent that includes phosphoric acid or a derivative thereof and silica having a particle size of 10 nm or less. JP-A-2004-214667 discloses a method that polishes a silicon nitride film using a polishing agent that includes phosphoric acid, nitric acid, and hydrofluoric acid, and has a pH of 1 to 5. JP-A-2006-120728 discloses a polishing agent that includes an acidic additive that suppresses an etching effect, and may selectively polish a silicon nitride film.

US2004209555 (A1) discloses a method of polishing a substrate, the method comprises the steps of (i) providing a polishing composition, (ii) providing a substrate comprising at least one metal layer, and (iii) abrading at least a portion of the metal layer with the polishing composition to polish the substrate. The polishing composition comprises an abrasive and a liquid carrier, wherein the abrasive comprises metal oxide particles having a surface with a silane compound adhered to a portion thereof and a polymer adhered to the silane compound and wherein the polymer is selected from the group consisting of water-soluble polymers and water-emulsifiable polymers. A polishing composition as described above is also provided, wherein the total amount of abrasive particles present in the polishing composition is no greater than about 20% by weight of the polishing composition, and the metal oxide particles do not comprise zirconia.

US 2007/202703 A1 discloses a method of selectively polishing a silicon nitride film using a composition containing silica grains exhibiting a negative zeta potential in the composition.

### SUMMARY OF THE INVENTION

### TECHNICAL PROBLEM

The chemical mechanical polishing aqueous dispersion disclosed in JP-A-11-176773 or JP-A-2004-214667 achieves a satisfactory selectivity ratio, but exhibits poor storage stability. Therefore, it is difficult to industrially apply the chemical mechanical polishing aqueous dispersion disclosed in JP-A-11-176773 or JP-A-2004-214667.

The chemical mechanical polishing aqueous dispersion disclosed in JP-A-2006-120728 requires a high polishing pressure (about 5 psi) in order to chemically and mechanically polish a silicon nitride film at a practical polishing rate. Moreover, the chemical mechanical polishing aqueous dispersion disclosed in JP-A-2006-120728 exhibits poor storage stability in a pH region where the chemical mechanical polishing aqueous dispersion achieves a high selectivity ratio. As a result, the pot life may decrease, or scratches may occur due to aggregated abrasive grains, for example.

Several aspects of the invention may solve the above problems, and may provide a chemical mechanical polishing aqueous dispersion that can achieve a sufficiently high polishing rate ratio of a silicon nitride film to a silicon oxide film without requiring a high polishing pressure, and exhibits excellent storage stability, and may also provide a chemical mechanical polishing method using the chemical mechanical polishing aqueous dispersion.

### SOLUTION TO PROBLEM

The invention was conceived in order to solve at least some of the above problems, and may be implemented as follows (see the following aspects and application examples).

### Application Example 1

According to the invention, there is provided a chemical mechanical polishing aqueous dispersion including (A) silica particles having a configuration in which at least one functional group selected from a group consisting of a sulfo group and salts thereof is covalenty bonded to the surface thereof, and (B) an acidic compound.

### Application Example 2

In the chemical mechanical polishing aqueous dispersion according to Application Example 1, the acidic compound (B) may be an organic acid.

### Application Example 3

The chemical mechanical polishing aqueous dispersion according to Application Example 1 or 2 may have a pH of 1 to 6.

### Application Example 4

In the chemical mechanical polishing aqueous dispersion according to Application Example 3, the silica particles (A) may have a zeta potential of -20 mV or less in the chemical mechanical polishing aqueous dispersion.

### Application Example 5

In the chemical mechanical polishing aqueous dispersion according to any one of Application Examples 1 to 4, the silica particles (A) may have an average particle size measured by a dynamic light scattering method of 15 to 100 nm.

### Application Example 6

A chemical mechanical polishing method comprising polishing a film using, the chemical mechanical polishing aqueous dispersion according to any one of Application Examples 1 to 5, wherein the chemical mechanical polishing aqueous dispersion is used to polish a film that is used together with another film when producing a semiconductor device, and is positively charged during chemical mechanical polishing.

### Application Example 7

The chemical mechanical polishing method according to Application Example 6, wherein the substrate that is positively charged during chemical mechanical polishing may be a silicon nitride film.

### ADVANTAGEOUS EFFECTS OF THE INVENTION

The surface of a silicon nitride film is positively charged, and the surface of a silicon oxide film is negatively charged during CMP used when producing a semiconductor device. Since the silica particles (A) have a configuration in which at least one functional group selected from the group consisting of a sulfo group and salts thereof is covalently bonded to the surface thereof, the surface of said silice particles is negatively charged, and the chemical mechanical polishing aqueous dispersion according to the invention can selectively polish a substrate (e.g., silicon nitride film) that is positively charged during CMP. Moreover, the silica particles (A) can achieve a high polishing rate ratio of a silicon nitride film to a silicon oxide film due to a synergistic effect with the acidic compound (B).

The chemical mechanical polishing aqueous dispersion can achieve the above effects particularly when polishing and removing a silicon nitride film used as a stopper when producing a semiconductor device in a state in which dishing of a silicon oxide film relative to the silicon nitride film has occurred due to CMP

### BRIEF DESCRIPTION OF DRAWINGS

FIG. 1 is a cross-sectional view schematically illustrating a polishing target that may suitably be subjected to a chemical mechanical polishing method according to one embodiment of the invention.
FIG. 2 is a cross-sectional view schematically illustrating a polishing target that has been subjected to a first polishing step.
FIG. 3 is a cross-sectional view schematically illustrating a polishing target that has been subjected to a second polishing step.
FIG. 4 is a perspective view schematically illustrating a chemical mechanical polishing system.
FIG. 5 is a cross-sectional view schematically illustrating a polishing target used in the experimental example.
FIG 6 is a cross-sectional view schematically illustrating a polishing target after preliminary polishing.
FIG. 7 is a cross-sectional view schematically illustrating a polishing target after polishing.

### DESCRIPTION OF EMBODIMENTS

### 1. Chemical mechanical polishing aqueous dispersion

A chemical mechanical polishing aqueous dispersion according to the invention includes (A) silica particles having a configuration in which at least one functional group selected from the group consisting of a sulfo group and salts thereof is covalently bonded to the surface thereof (hereinafter may be referred to as "silica particles (A)"), and (B) an acidic compound. Each component of the chemical mechanical polishing aqueous dispersion according to the invention is described in detail below.

### 1.1. Silica particles (A)

The chemical mechanical polishing aqueous dispersion according to the invention includes the silica particles (A) as abrasive grains. Note that the silica particles (A) refer to silica particles having a configuration in which at least one functional group selected from the group consisting of a sulfo group and salts thereof is covalently bonded to the surface thereof, and exclude silica particles having a configuration in which a compound that includes at least one functional group selected from the group consisting of a sulfo group and salts thereof is physically or ionically bonded to the surface thereof. Note that the term "salts of a sulfo group" used herein refers to a functional group obtained by substituting the hydrogen ion of a sulfo group (-SO₃H) with a cation (e.g., metal ion or ammonium ion).

The silica particles (A) may be produced by the following method.

Specifically, silica particles are provided. Examples of the silica particles include fumed silica, colloidal silica, and the like. Among these, colloidal silica is preferable since polishing defects (e.g., scratches) can be reduced. Colloidal silica produced by a known method such as the method disclosed in JP-A-2003-109921 may be used, for example. The silica particles (A) may be produced by modifying the surface of the silica particles thus provided. The surface of the silica particles may be modified as described below, for example. Note that the surface of the silica particles may be modified by an arbitrary method.

The surface of the silica particles may be modified by a known method such as the method disclosed in JP-A-2010-269985 or J. Ind. Eng. Chem., Vol. 12, No. 6, (2006) 911-917. For example, the silica particles and a mercapto group-containing silane coupling agent are sufficiently mixed in an acidic medium so that the mercapto group-containing silane coupling agent is covalently bonded to the surface of the silica particles. Examples of the mercapto group-containing silane coupling agent include 3-mercaptopropylmethyldimethoxysilane, 3-mercaptopropyltrimethoxysilane, and the like.

After the addition of an adequate amount of hydrogen peroxide, the mixture is allowed to stand for a sufficient time to obtain silica particles that include at least one functional group selected from the group consisting of a sulfo group and salts thereof.

The average particle size of the silica particles (A) may be determined by subjecting the chemical mechanical polishing aqueous dispersion according to one embodiment of the invention to particle size measurement using a dynamic light scattering method. The average particle size of the silica particles (A) is preferably 15 to 100 nm, and more preferably 30 to 70 nm. When the average particle size of the silica particles (A) is within the above range, a practical polishing rate may be achieved. It may also be possible to decrease the polishing rate of a silicon oxide film. Examples of a particle size measurement system that utilizes a dynamic light scattering method include a nanoparticle analyzer "DelsaNano S" (manufactured by Beckman Coulter, Inc.), Zetasizer Nano ZS (manufactured by Malvern Instruments Ltd.), and the like. Note that the average particle size measured using a dynamic light scattering method indicates the average particle size of secondary particles that are formed of aggregated primary particles.

When the chemical mechanical polishing aqueous dispersion has a pH of 1 to 6, the silica particles (A) have a negative zeta potential in the chemical mechanical polishing aqueous dispersion. The zeta potential of the silica particles (A) is preferably -20 mV or less. When the zeta potential of the silica particles (A) is -20 mV or less, it may be possible to effectively suppress aggregation of the particles due to electrostatic repulsion between the particles, and selectively polish a substrate that is positively charged during CMP. Examples of a zeta potential analyzer include ELSZ-1 (manufactured by Otsuka Electronics Co., Ltd.), Zetasizer Nano ZS (manufactured by Malvern Instruments Ltd.), and the like. The zeta potential of the silica particles (A) may be appropriately adjusted by increasing or decreasing the amount of the mercapto group-containing silane coupling agent mixed with the silica particles.

The content of the silica particles (A) in the chemical mechanical polishing aqueous dispersion is preferably 1 to 10 mass%, more preferably 2 to 8 mass%, and particularly preferably 3 to 6 mass%, based on the total mass of the chemical mechanical polishing aqueous dispersion.

### 1.2. Acidic compound (B)

The chemical mechanical polishing aqueous dispersion according to the invention includes the acidic compound (B). Examples of the acidic compound (B) include an organic acid and an inorganic acid. The chemical mechanical polishing aqueous dispersion according to one embodiment of the invention may include at least one compound selected from an organic acid and an inorganic acid. The acidic compound (B) has an effect of increasing the polishing rate of a silicon nitride film due to a synergistic effect with the silica particles (A).

Examples of an organic acid include, but are not limited to, malonic acid, maleic acid, citric acid, malic acid, tartaric acid, oxalic acid, lactic acid, and salts thereof.

Examples of an inorganic acid include, but are not limited to, phosphoric acid, sulfuric acid, hydrochloric acid, nitric acid, salts thereof, and derivatives thereof.

These acidic compounds (B) may be used either alone or in combination.

When polishing a silicon nitride film, it is preferable to use an organic acid (more preferably tartaric acid, malic acid, or citric acid, and particularly preferably tartaric acid) as the acidic compound (B). Tartaric acid, malic acid, and citric acid include two or more carboxyl groups and one or more hydroxyl groups in the molecule. Since a hydroxyl group can be bonded to a nitrogen atom included in a silicon nitride film via a hydrogen bond, it is possible to allow a large amount of organic acid to be present on the surface of a silicon nitride film. Therefore, the polishing rate of a silicon nitride film can be increased due to the etching effect of the carboxyl groups included in the organic acid.

A silicon nitride film can be polished at a higher polishing rate when using tartaric acid, malic acid, or citric acid as the acidic compound (B).

The content of the acidic compound (B) in the chemical mechanical polishing aqueous dispersion is preferably 0.1 to 5 mass%, more preferably 0.2 to 1 mass%, and particularly preferably 0.2 to 0.5 mass%, based on the total mass of the chemical mechanical polishing aqueous dispersion.

### 1.3. Dispersion medium

The chemical mechanical polishing aqueous dispersion according to one embodiment of the invention includes a dispersion medium. Examples of the dispersion medium include water, a mixed medium of water and an alcohol, a mixed medium of water and a water-miscible organic solvent, and the like. It is preferable to use water or a mixed medium of water and an alcohol. It is more preferable to use water.

### 1.4. Additive

The chemical mechanical polishing aqueous dispersion according to one embodiment of the invention may further include an optional additive such as a surfactant, a water-soluble polymer, an anti-corrosion agent, or a pH adjusting agent. Each additive is described below.

### 1.4.1. Surfactant

The chemical mechanical polishing aqueous dispersion according to one embodiment of the invention may further include a surfactant, if necessary. The surfactant provides an adequate viscosity to the chemical mechanical polishing aqueous dispersion. It is preferable that the surfactant be added so that the chemical mechanical polishing aqueous dispersion has a viscosity at 25°C of 0.5 mPa·s or more and less than 10 mPa·s.

Examples of the surfactant include, but are not limited to, an anionic surfactant, a cationic surfactant, a nonionic surfactant, and the like.

Examples of the anionic surfactant include carboxylates (e.g., fatty acid soaps and alkyl ether carboxylates); sulfonates (e.g., alkylbenzenesulfonates, alkylnaphthalenesulfonates, and alpha-olefin sulfonates); sulfates (e.g., higher alcohol sulfate salts, alkyl ether sulfates, and polyoxyethylene alkyl phenyl ether sulfates); phosphate salts (e.g., alkyl phosphate salts); fluorine-containing surfactants (e.g., perfluoroalkyl compounds); and the like.

Examples of the cationic surfactant include aliphatic amine salts, aliphatic ammonium salts, and the like.

Examples of the nonionic surfactant include nonionic surfactants having a triple bond (e.g., acetylene glycol, acetylene glycol ethylene oxide adduct, and acetylene alcohol); polyethylene glycol-type surfactants, and the like. Polyvinyl alcohol, cyclodextrin, polyvinyl methyl ether, hydroxyethyl cellulose, or the like may also be used as the nonionic surfactant.

Among these, alkylbenzenesulfonates are preferable, and potassium dodecylbenzenesulfonate and ammonium dodecylbenzenesulfonate are more preferable.

These surfactants may be used either alone or in combination.

The content of the surfactant in the chemical mechanical polishing aqueous dispersion is preferably 0.001 to 5 mass%, more preferably 0.01 to 0.5 mass%, and particularly preferably 0.05 to 0.2 mass%, based on the total mass of the chemical mechanical polishing aqueous dispersion.

### 1.4.2. Water-soluble polymer

The chemical mechanical polishing aqueous dispersion according to one embodiment of the invention may further include a water-soluble polymer, if necessary. The water-soluble polymer is adsorbed on the surface of a silicon nitride film, and reduces friction due to polishing. This makes it possible to suppress occurrence of dishing of a silicon nitride film.

Examples of the water-soluble polymer include polyacrylamide, polyacrylic acid, polyvinyl alcohol, polyvinylpyrrolidone, hydroxyethyl cellulose, and the like.

The water-soluble polymer may be added so that the chemical mechanical polishing aqueous dispersion has a viscosity of less than 10 mPa·s.

### 1.4.3. Anti-corrosion agent

The chemical mechanical polishing aqueous dispersion according to one embodiment of the invention may further include an anti-corrosion agent, if necessary. Examples of the anti-corrosion agent include benzotriazole and benzotriazole derivatives. Note that the term "benzotriazole derivatives" used herein refers to a compound obtained by substituting at least one hydrogen atom of benzotriazole with a carboxyl group, a methyl group, an amino group, a hydroxyl group, or the like. Examples of the benzotriazole derivatives include 4-carboxybenzotriazole, salts thereof, 7-carboxybenzotriazole, salts thereof, benzotriazole butyl ester, 1-hydroxymethylbenzotriazole, 1-hydroxybenzotriazole, and the like.

The content of the anti-corrosion agent in the chemical mechanical polishing aqueous dispersion is preferably 1 mass% or less, and more preferably 0.001 to 0.1 mass%, based on the total mass of the chemical mechanical polishing aqueous dispersion.

### 1.4.4. pH adjusting agent

The chemical mechanical polishing aqueous dispersion according to one embodiment of the invention may further include a pH adjusting agent, if necessary. Examples of the pH adjusting agent include basic compounds such as potassium hydroxide, ethylenediamine, tetramethylammonium hydroxide (TMAH), and ammonia. Since the chemical mechanical polishing aqueous dispersion according to one embodiment of the invention includes the acidic compound (B), these basic compounds may be used to adjust the pH of the chemical mechanical polishing aqueous dispersion. 1.5. pH

The pH of the chemical mechanical polishing aqueous dispersion according to one embodiment of the invention is not particularly limited, but is preferably 1 to 6, and more preferably 2 to 4. If the pH of the chemical mechanical polishing aqueous dispersion is within the above range, the polishing rate of a silicon nitride film can be increased while reducing the polishing rate of a silicon oxide film. Therefore, a silicon nitride film can be selectively polished. When the pH of the chemical mechanical polishing aqueous dispersion is 2 to 4, the chemical mechanical polishing aqueous dispersion exhibits excellent storage stability.

### 1.6. Applications

The chemical mechanical polishing aqueous dispersion according to the invention is used as a polishing agent for polishing a film that is used together with another film when producing a semiconductor device, and is positively charged during CMP. Examples of a typical substrate that is positively charged during CMP include a silicon nitride film, doped polysilicon, and the like. The chemical mechanical polishing aqueous dispersion according to one embodiment of the invention is particularly suitable for polishing a silicon nitride film.

When separately polishing a silicon oxide film and a silicon nitride film under the same polishing conditions using the chemical mechanical polishing aqueous dispersion according to one embodiment of the invention, the polishing rate ratio of the silicon nitride film to the silicon oxide film is preferably 3 or more, and more preferably 4 or more.

### 1.7. Preparation of chemical mechanical polishing aqueous dispersion

The chemical mechanical polishing aqueous dispersion according to one embodiment of the invention may be prepared by dissolving or dispersing the above components in the dispersion medium (e.g., water). The components may be dissolved or dispersed in the dispersion medium using an arbitrary method insofar as the components can be uniformly dissolved or dispersed in the dispersion medium. The components may be mixed in an arbitrary order by an arbitrary method.

The chemical mechanical polishing aqueous dispersion according to one embodiment of the invention may be prepared as a concentrated dispersion, and diluted with the dispersion medium (e.g., water) before use.

### 2. Chemical mechanical polishing method

A chemical mechanical polishing method according to the invention includes polishing a film (e.g., silicon nitride film) using the chemical mechanical polishing aqueous dispersion according to the invention, the film being used together with another film when producing a semiconductor device, and positively charged during CMP. A specific example of the chemical mechanical polishing method according to one embodiment of the invention is described in detail below with reference to the drawings.

### 2.1. Polishing target

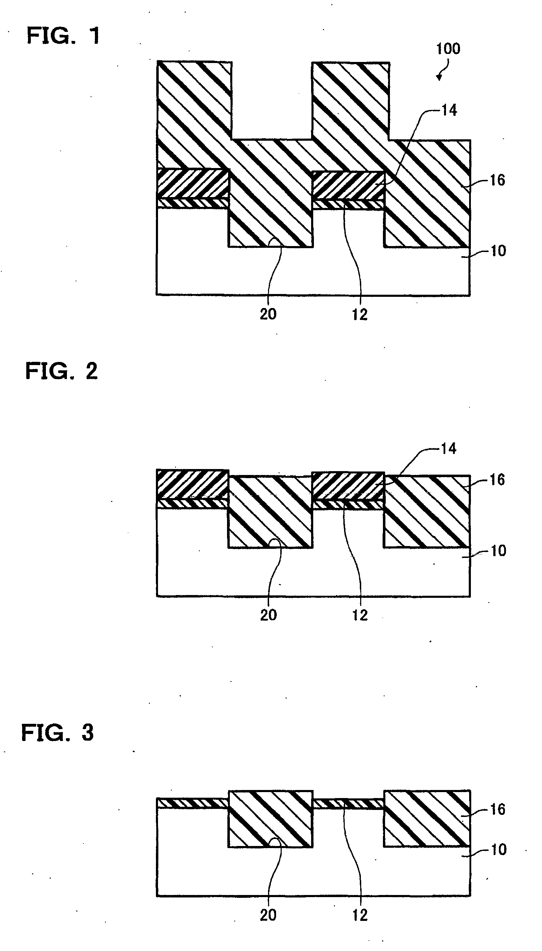

FIG. 1 is a cross-sectional view schematically illustrating a polishing target that may suitably be subjected to the chemical mechanical polishing method according to one embodiment of the invention. A polishing target 100 illustrated in FIG. 1 is formed by performing the following steps (1) to (4).
(1) A silicon substrate 10 is provided. A functional device (e.g., transistor) (not illustrated in FIG. 1) may be formed on the silicon substrate 10.
(2) A first silicon oxide film 12 is formed on the silicon substrate 10 using a CVD method or a thermal oxidation method. A silicon nitride film 14 is then formed on the first silicon oxide film 12 using a CVD method.
(3) The silicon nitride film 14 is patterned. Trenches 20 are then formed by lithography or etching using the silicon nitride film 14 as a mask.
(4) A second silicon oxide film 16 is deposited using a high-density plasma CVD method so that the trenches 20 are filled with the second silicon oxide film 16. The polishing target 100 is thus obtained.

### 2.2. Chemical mechanical polishing method

### 2.2.1. First polishing step

The polishing target 100 (see FIG. 1) is subjected to a first polishing step using a chemical mechanical polishing aqueous dispersion having a high silicon oxide film selectivity ratio to remove the second silicon oxide film 16 deposited on the silicon nitride film 14. FIG. 2 is a cross-sectional view schematically illustrating the polishing target that has been subjected to the first polishing step. In the first polishing step, the silicon nitride film 14 serves as a stopper so that polishing can be stopped when the surface of the silicon nitride film 14 has been exposed. In this case, dishing occurs in the trenches 20 that are filled with silicon oxide. Note that a polishing residue of the second silicon oxide film 16 may remain on the silicon nitride film 14 (see FIG. 2). The silicon nitride film 14 may not be smoothly polished when a polishing residue remains on the silicon nitride film 14.

### 2.2.2. Second polishing step

The polishing target 100 is then subjected to a second polishing step using the chemical mechanical polishing aqueous dispersion according to one embodiment of the invention to remove the silicon nitride film 14 (see FIG. 2). FIG. 3 is a cross-sectional view schematically illustrating the polishing target that has been subjected to the second polishing step. The chemical mechanical polishing aqueous dispersion according to one embodiment of the invention achieves a sufficiently high polishing rate ratio of a silicon nitride film to a silicon oxide film, but can polish a silicon oxide film at a moderate polishing rate. Therefore, it is possible to polish and remove the silicon nitride film 14 smoothly without being affected by a polishing residue of the silicon oxide film. A semiconductor device in which the trenches 20 are filled with silicon oxide (see FIG. 3) can thus be obtained. The chemical mechanical polishing method according to one embodiment of the invention may be applied to shallow trench isolation (STI), for example.

### 2.3. Chemical mechanical polishing system

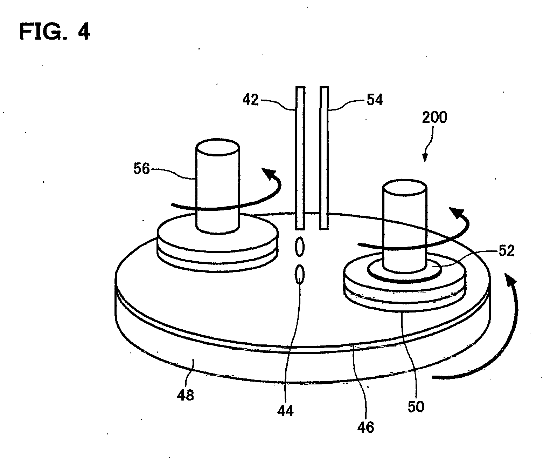

A chemical mechanical polishing system 200 illustrated in FIG. 4 may be used when performing the first polishing step and the second polishing step, for example. FIG. 4 is a perspective view schematically illustrating the chemical mechanical polishing system 200. Each polishing step is performed by bringing a carrier head 52 that holds a semiconductor substrate 50 into contact with a turntable 48 to which an abrasive cloth 46 is attached while supplying a slurry (chemical mechanical polishing aqueous dispersion) 44 from a slurry supply nozzle 42 and rotating the turntable 48. FIG. 4 also illustrates a water supply nozzle 54 and a dresser 56.

The pressing pressure of the carrier head 52 may be selected within a range of 10 to 1000 hPa, and is preferably 30 to 500 hPa. The rotational speed of the turntable 48 and the carrier head 52 may be appropriately selected within a range of 10 to 400 rpm, and is preferably 30 to 150 rpm. The flow (supply) rate of the slurry (chemical mechanical polishing aqueous dispersion) 44 supplied from the slurry supply nozzle 42 may be selected within a range of 10 to 1000 ml/min, and is preferably 50 to 400 ml/min.

Examples of a commercially available chemical mechanical polishing system include EPO-112 and EPO-222 (manufactured by Ebara Corporation); LGP510 and LGP552 (manufactured by Lapmaster SFT Corporation); Mirra and Reflexion (manufactured by Applied Materials, Inc.); and the like.

### 3. Examples

The invention is further described below by way of examples.

### 3.1. Preparation of aqueous dispersion containing colloidal silica

A 2000 cm³ flask was charged with 70 g of 25 mass% aqueous ammonia, 40 g of ion-exchanged water, 175 g of ethanol, and 21 g of tetraethoxysilane. The mixture was heated to 60°C while stirring the mixture at 180 rpm. The mixture was then stirred at 60°C for 1 hour, and cooled to obtain a colloidal silica/alcohol dispersion. An operation of evaporating the alcohol from the dispersion at 80°C using an evaporator while adding ion-exchanged water to the dispersion was performed several times to remove the alcohol from the dispersion. An aqueous dispersion having a solid content of 15% was thus prepared. A sample was prepared by diluting a portion of the aqueous dispersion with ion-exchanged water. The arithmetic average particle size (average particle size) of the colloidal silica contained in the sample was measured using a dynamic light-scattering particle size analyzer ("LB550" manufactured by Horiba Ltd.), and found to be 35 nm.

An aqueous dispersion containing colloidal silica having an average particle size of 10, 50, 70, or 130 nm was respectively prepared in the same manner as described above, except for appropriately changing the amount of tetraethoxysilane and the stirring time.

Note that the aqueous dispersion containing colloidal silica thus prepared is indicated by "Silica type: B" in Tables 1 and 2.

### 3.2. Preparation of aqueous dispersion containing sulfo group-modified colloidal silica

5 g of acetic acid was added to 50 g of ion-exchanged water, and 5 g of a mercapto group-containing silane coupling agent ("KBE803" manufactured by Shin-Etsu Chemical Co., Ltd.) was slowly added dropwise to the mixture with stirring. After 30 minutes had elapsed, 1000 g of the aqueous dispersion containing colloidal silica having an average particle size of 35 nm that was prepared in the section "3.1. Preparation of aqueous dispersion containing colloidal silica" was added to the mixture. The mixture was then stirred for 1 hour. After the addition of 200 g of a 31 % hydrogen peroxide solution, the mixture was allowed to stand at room temperature for 48 hours to obtain an aqueous dispersion containing colloidal silica including at least one functional group selected from the group consisting of a sulfo group and salts thereof. A sample was prepared by diluting a portion of the aqueous dispersion with ion-exchanged water. The arithmetic average particle size (average particle size) of the colloidal silica contained in the sample was measured using a dynamic light-scattering particle size analyzer ("LB550" manufactured by Horiba Ltd.), and found to be 35 nm.

The aqueous dispersion containing colloidal silica having an average particle size of 10, 50, 70, or 130 nm was respectively subjected to surface modification using a sulfo group in the same manner as described above to prepare an aqueous dispersion containing sulfo group-modified colloidal silica. The average particle size of the colloidal silica contained in each aqueous dispersion was measured in the same manner as described above. It was confirmed that the average particle size of the colloidal silica did not change due to surface modification.

Note that the aqueous dispersion containing sulfo group-modified colloidal silica thus prepared is indicated by "Silica type: A" in Tables 1 and 2.

### 3.3. Preparation of chemical mechanical polishing aqueous dispersion

A 1000 cm³ polyethylene bottle was charged with a given amount of the aqueous dispersion prepared in the section "3.2. Preparation of aqueous dispersion containing sulfo group-modified colloidal silica". After the addition of the acidic substance shown in Table 1 or 2 in the amount shown in Table 1 or 2, the mixture was sufficiently stirred. After the addition of ion-exchanged water to the mixture with stirring so that the mixture had a given silica concentration, ammonia was added to the mixture so that the mixture had the pH shown in Table 1 or 2. The mixture was then filtered through a filter having a pore size of 5 micrometers to obtain a chemical mechanical polishing aqueous dispersion (Examples 1 to 10 and Comparative Examples 1 to 5).

The zeta potential of the sulfo group-modified colloidal silica contained in the chemical mechanical polishing aqueous dispersion was measured using a zeta potential analyzer ("ELSZ-1" manufactured by Otsuka Electronics Co., Ltd.). The results are shown in Tables 1 and 2.

### 3.4. Chemical mechanical polishing test

An 8-inch silicon substrate (polishing target), on which a silicon nitride film or a silicon oxide film was formed, was chemically and mechanically polished under the following polishing conditions 1 using each chemical mechanical polishing aqueous dispersion prepared in the section "3.3. Preparation of chemical mechanical polishing aqueous dispersion".

### Polishing conditions 1

Polishing system: EPO-112 manufactured by Ebara Corporation
Polishing pad: IC1000/K-Groove manufactured by Rodel Nitta
Chemical mechanical polishing aqueous dispersion supply rate: 200 ml/min
Platen rotational speed: 90 rpm
Polishing head rotational speed: 90 rpm
Polishing head pressing pressure: 140 hPa

### 3.4.1. Calculation of polishing rate

The thickness of the 8-inch silicon substrate (polishing target) before polishing was measured using an optical interference-type thickness meter ("NanoSpec 6100" manufactured by Nanometrics Japan Ltd.). The polishing target was polished for 1 minute under the above conditions. The thickness of the polishing target was measured after polishing using the optical interference-type thickness meter, and the difference between the thickness before polishing and the thickness after polishing (i.e., the thickness reduced by CMP) was calculated. The polishing rate was calculated from the polishing time and the thickness reduced by CMP. The results are shown in Tables 1 and 2.

### 3.4.2. Evaluation of storage stability

500 cc of the chemical mechanical polishing aqueous dispersion prepared in the section "3.3. Preparation of chemical mechanical polishing aqueous dispersion" was put in a 500 cc polyethylene bottle, and stored at 25°C for 2 weeks. The arithmetic average particle size (average particle size) of the colloidal silica contained in the chemical mechanical polishing aqueous dispersion was determined after storage using a dynamic light-scattering particle size analyzer ("LB550" manufactured by Horiba Ltd.). A change in average particle size of the colloidal silica due to storage was then evaluated. The storage stability of the chemical mechanical polishing aqueous dispersion was evaluated as "Excellent" when the average particle size increased by less than 5% due to storage, evaluated as "Good" when the average particle size increased by 5% or more and less than 10% due to storage, and evaluated as "Unacceptable" when the average particle size increased by 10% or more due to storage (see Tables 1 and 2).

### 3.4.3. Evaluation results

When using the chemical mechanical polishing aqueous dispersions of Examples 1 to 10, the polishing rate ratio of a silicon nitride film to a silicon oxide film was 3 or more.

The chemical mechanical polishing aqueous dispersion of Comparative Example 1 contained the sulfo group-modified colloidal silica, but did not contain an acidic substance. When using the chemical mechanical polishing aqueous dispersion of Comparative Example 1, the polishing rate ratio of a silicon nitride film to a silicon oxide film was insufficient.

The chemical mechanical polishing aqueous dispersions of Comparative Examples 2 to 4 contained unmodified colloidal silica and a different acidic substance. When using the chemical mechanical polishing aqueous dispersions of Comparative Examples 2 to 4, the polishing rate ratio of a silicon nitride film to a silicon oxide film was small, and the storage stability was poor.

The chemical mechanical polishing aqueous dispersion of Comparative Example 5 contained unmodified colloidal silica having a small average particle size. When using the chemical mechanical polishing aqueous dispersion of Comparative Example 5, the polishing rate was too low, and the storage stability was poor, in spite of a high polishing rate ratio of a silicon nitride film to a silicon oxide film.

**TABLE 1**

| | | Example 1 | Example 2 | Example 3 | Example 4 | Example 5 | Example 6 | Example 7 | Examples 8 | Example 9 | Example 10 |
|---|---|---|---|---|---|---|---|---|---|---|---|
| (A) Colloidal silica | Silica type | A | A | A | A | A | A | A | A | A | A |
| | Average particle size (nm) | 50 | 70 | 35 | 70 | 70 | 50 | 70 | 70 | 10 | 130 |
| | Content (mass%) | 4 | 6 | 5 | 5 | 5 | 5 | 3.5 | 5 | 5 | 5 |
| (B) Acidic substance (mass%) | Tartaric acid | | | | 0.3 | | | | | | |
| | Citric acid | 0.5 | 0.5 | 0.5 | | | | | | | |
| | Malonic acid | | | | | 0.5 | | | 0.2 | 0.5 | 0.5 |
| | Acetic acid | | | | | | | | | | |
| | Sulfuric acid | | | | | | 0.5 | | 0.3 | | |
| | Hydrochloric acid | | | | | | | | | | |
| | Phosphoric acid | | | | | | | 0.5 | | | |
| pH | | 4.2 | 2.6 | 2.6 | 3.2 | 2.1 | 1.5 | 1.9 | 1.8 | 2.1 | 2 |
| Zeta potential (mV) | | -45 | -40 | -32 | -40 | -40 | -45 | -40 | -40 | -25 | *-*50 |
| Polishing rate (angstroms/min) | Silicon nitride film (SiN) | 505 | 585 | 570 | 505 | 555 | 585 | 475 | 575 | 320 | 535 |
| | Silicon oxide film (TEOS) | 155 | 135 | 85 | 115 | 135 | 185 | 155 | 190 | 65 | 180 |
| Polishing rate ratio | SiN/TEOS | 3.3 | 4.3 | 6.7 | 4.4 | 4.1 | 3.2 | 3.1 | 3.0 | 4.9 | 3.0 |
| Slurry storage stability | | Good | Excellent | Excellent | Excellent | Excellent | Excellent | Excellent | Excellent | Excellent | Good |

**TABLE 2**

| | | Comparative Example 1 | Comparative Example 2 | Comparative Example 3 | Comparative Example 4 | Comparative Example 5 |
|---|---|---|---|---|---|---|
| (A) Colloidal silica | Silica type | A | B | B | B | B |
| | Average particle size (nm) | 70 | 50 | 70 | 70 | 10 |
| | Content (mass%) | 5 | 4 | 5 | 5 | 5 |
| (B) Acidic substance (mass%) | Tartaric acid | None | | | | |
| | Citric acid | | 0.5 | | | |
| | Malonic acid | | | | | |
| | Acetic acid | | | | | 0.5 |
| | Sulfuric acid | | | 0.5 | | |
| | Hydrochloric acid | | | | 0.5 | |
| | Phosphoric acid | | | | | |
| pH | | 7.5 | 4.2 | 1.5 | 1.6 | 3.2 |
| Zeta potential (mV) | | -40 | -5 | 2 | 2 | -8 |
| Polishing rate (angstroms/min) | Silicon nitride film (SiN) | 25 | 412 | 581 | 318 | 135 |
| | Silicon oxide film (TEOS) | 175 | 586 | 666 | 714 | 25 |
| Polishing rate ratio | SiN/TEOS | 0.14 | 0.7 | 0.9 | 0.4 | 5.4 |
| Slurry storage stability | | Excellent | Unacceptable | Unacceptable | Unacceptable | Unacceptable |

### 3.5. Experimental Example

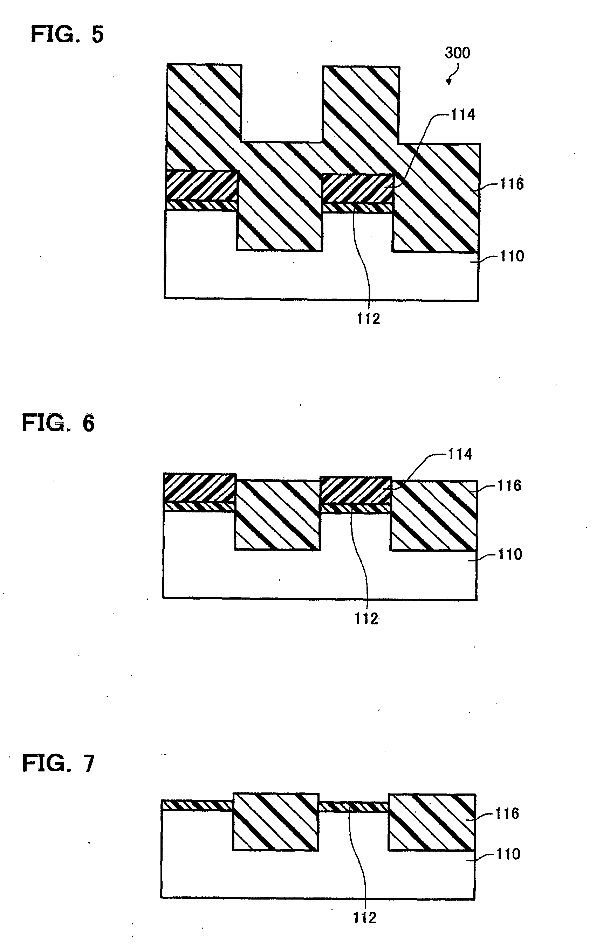

A test wafer in which a silicon nitride film was embedded was chemically and mechanically polished. Specifically, a test wafer "864CMP" (manufactured by Advanced Materials Technology Inc.) was used as a polishing target 300. The test wafer "864CMP" has the cross-sectional structure illustrated in FIG. 5, and is produced by sequentially depositing a first silicon oxide film 112 and a silicon nitride film 114 on a bare silicon wafer 110, forming grooves by lithography, and depositing a second silicon oxide film 116 using a high-density plasma CVD method.

The test wafer was preliminarily polished under the following polishing conditions 2 using CMS4301 and CMS4302 (manufactured by JSR Corporation) until the top surface of the silicon nitride film 114 was exposed. Whether or not the silicon nitride film 114 was exposed was determined by detecting a change in table torque current of the polishing system using an endpoint detector.

### Polishing conditions 2

Polishing system: EPO-112 manufactured by Ebara Corporation
Polishing pad: IC1000/K-Groove manufactured by Rodel Nitta
Chemical mechanical polishing aqueous dispersion supply rate: 200 ml/min
Platen rotational speed: 100 rpm
Carrier head rotational speed: 110 rpm
Carrier pressing pressure: 210 hPa

FIG. 6 is a cross-sectional view schematically illustrating the state of the polishing target (test wafer "864CMP") after preliminary polishing. The second silicon oxide film 116 formed on the silicon nitride film 114 was completely removed by CMP (see FIG. 6). The thickness of the silicon nitride film 114 within a 100-micrometer pitch (pattern density: 50%) was measured using an optical interference-type thickness meter "NanoSpec 6100", and found to be about 150 nm.

The depth of dishing of the second silicon oxide film 116 relative to the silicon nitride film 114 was measured using a contact-type profilometer "HRP240", and found to be about 40 nm.

The polishing target 300 was then chemically and mechanically polished for 150 seconds under the polishing conditions 1 using the chemical mechanical polishing aqueous dispersion of Example 1. FIG. 7 is a cross-sectional view schematically illustrating the state of the polishing target (test wafer "864CMP") after polishing.

The thickness of the silicon nitride film 114 after polishing was almost 0 nm (see FIG. 7). The depth of dishing within a 100-micrometer pitch (pattern density: 50%) was about 20 nm. Therefore, it was found that the chemical mechanical polishing aqueous dispersion may suitably be applied to shallow trench isolation.

As is clear from the above results, since the chemical mechanical polishing aqueous dispersion according to one embodiment of the invention achieves a sufficiently high polishing rate ratio of a silicon nitride film to a silicon oxide film, the chemical mechanical polishing aqueous dispersion can selectively polish a silicon nitride film when producing a semiconductor device using a silicon oxide film and a silicon nitride film.

### REFERENCE SIGNS LIST

10/110: silicon substrate (bare silicon), 12/112: first silicon oxide film, 14/114: silicon nitride film, 16/116: second silicon oxide film, 20: trench, 42: slurry supply nozzle, 44: slurry, 46: abrasive cloth, 48: turntable, 50: semiconductor substrate, 52: carrier head, 54: water supply nozzle, 56: dresser, 100/300: polishing target, 200: chemical mechanical polishing system

## Claims

1. A chemical mechanical polishing aqueous dispersion comprising (A) silica particles and (B) an acidic compound;
the chemical mechanical aqueous dispersion is **characterized in that** the silica particles have a configuration in which at least one functional group selected from a group consisting of a sulfo group and salts thereof is covalently bonded to the surface thereof.

2. The chemical mechanical polishing aqueous dispersion according to claim 1, wherein the acidic compound (B) is an organic acid.

3. The chemical mechanical polishing aqueous dispersion according to claim 1 or 2, the chemical mechanical polishing aqueous dispersion having a pH of 1 to 6.

4. The chemical mechanical polishing aqueous dispersion according to claim 3, wherein the silica particles (A) have a zeta potential of -20 mV or less in the chemical mechanical polishing aqueous dispersion.

5. The chemical mechanical polishing aqueous dispersion according to any one of claims 1 to 4, wherein the silica particles (A) have an average particle size measured by a dynamic light scattering method of 15 to 100 nm.

6. A chemical mechanical polishing method comprising polishing a film using the chemical mechanical polishing aqueous dispersion according to any one of claims 1 to 5, wherein the chemical mechanical polishing aqueous dispersion is used to polish a film that is used together with another film when producing a semiconductor device, and is positively charged during chemical mechanical polishing.

7. The chemical mechanical polishing method according to claim 6, wherein the film that is positively charged during chemical mechanical polishing is a silicon nitride film.

## Patentansprüche

1. Wässrige chemisch-mechanische Polierdispersion, die (A) Siliziumdioxidteilchen und (B) eine saure Verbindung umfasst;
die wässrige chemisch-mechanische Dispersion ist **dadurch gekennzeichnet, dass** die Siliziumdioxidteilchen eine Konfiguration aufweisen, in welcher zumindest eine funktionelle Gruppe, die aus einer Gruppe ausgewählt ist, die aus einer Sulfogruppe und Salzen davon besteht, kovalent an die Oberfläche davon gebunden ist.

2. Wässrige chemisch-mechanische Polierdispersion nach Anspruch 1, wobei die saure Verbindung (B) eine organische Säure ist.

3. Wässrige chemisch-mechanische Polierdispersion nach Anspruch 1 oder 2, wobei die wässrige chemisch-mechanische Polierdispersion einen pH von 1 bis 6 aufweist.

4. Wässrige chemisch-mechanische Polierdispersion nach Anspruch 3, wobei die Siliziumdioxidteilchen (A) ein Zetapotential von -20 mV oder weniger in der wässrigen chemisch-mechanischen Polierdispersion aufweisen.

5. Wässrige chemisch-mechanische Polierdispersion nach einem der Ansprüche 1 bis 4, wobei die Siliziumdioxidteilchen (A) eine durchschnittliche Teilchengröße von 15 bis 100 nm aufweisen, die durch ein dynamisches Lichtstreuverfahren gemessen ist.

6. Chemisch-mechanisches Polierverfahren, das das Polieren eines Films unter Verwendung der wässrigen chemisch-mechanischen Polierdispersion nach einem der Ansprüche 1 bis 5 umfasst, wobei die wässrige chemisch-mechanische Polierdispersion verwendet wird, um einen Film zu polieren, der zusammen mit einem weiteren Film verwendet wird, wenn eine Halbleitervorrichtung hergestellt wird, und während chemisch-mechanischem Polieren positiv geladen wird.

7. Chemisch-mechanisches Polierverfahren nach Anspruch 6, wobei der Film, der während chemisch-mechanischem Polieren positiv geladen wird, ein Siliziumnitridfilm ist.

## Revendications

1. Dispersion aqueuse de polissage chimico-mécanique comprenant (A) des particules de silice et (B) un composé acide ;
la dispersion aqueuse chimico-mécanique est **caractérisée en ce que** les particules de silice ont une configuration dans laquelle au moins un groupe fonctionnel choisi dans un groupe constitué d'un groupe sulfo et de sels de celui-ci est lié de manière covalente à la surface de celles-ci.

2. Dispersion aqueuse de polissage chimico-mécanique selon la revendication 1, dans laquelle le composé acide (B) est un acide organique.

3. Dispersion aqueuse de polissage chimico-mécanique selon la revendication 1 ou 2, la dispersion aqueuse de polissage chimico-mécanique ayant un pH allant de 1 à 6.

4. Dispersion aqueuse de polissage chimico-mécanique selon la revendication 3, dans laquelle les particules de silice (A) ont un potentiel zêta inférieur ou égal à -20 mV dans la dispersion aqueuse de polissage chimico-mécanique.

5. Dispersion aqueuse de polissage chimico-mécanique selon l'une quelconque des revendications 1 à 4, dans laquelle les particules de silice (A) ont une taille moyenne de particules, mesurée par un procédé de diffusion dynamique de la lumière, allant de 15 à 100 nm.

6. Dispersion aqueuse de polissage chimico-mécanique comprenant le polissage d'un film en utilisant la dispersion aqueuse de polissage chimico-mécanique selon l'une quelconque des revendications 1 à 5, dans laquelle la dispersion aqueuse de polissage chimico-mécanique est utilisée pour polir un film qui est utilisé conjointement avec un autre film lors de la production d'un dispositif semi-conducteur, et est chargé positivement au cours du polissage chimico-mécanique.

7. Procédé de polissage chimico-mécanique selon la revendication 6, dans laquelle le film qui est chargé positivement au cours du polissage mécano-chimique est un film de nitrure de silicium.
